Europäisches Patentamt

European Patent Office

Office européen des brevets

(19)

(11) **EP 1 406 094 A1**

(12) **EUROPÄISCHE PATENTANMELDUNG**

(43) Veröffentlichungstag:
   **07.04.2004 Patentblatt 2004/15**

(51) Int Cl.⁷: **G01R 19/00**, G01R 15/18,
   G01R 15/20

(21) Anmeldenummer: **03009025.2**

(22) Anmeldetag: **17.04.2003**

(84) Benannte Vertragsstaaten:
   **AT BE BG CH CY CZ DE DK EE ES FI FR GB GR
   HU IE IT LI LU MC NL PT RO SE SI SK TR**
   Benannte Erstreckungsstaaten:
   **AL LT LV MK**

(30) Priorität: **31.08.2002 DE 10240242**

(71) Anmelder: **ROBERT BOSCH GMBH**
   **70442 Stuttgart (DE)**

(72) Erfinder: **Hauenstein, Henning**
   **72762 Reutlingen (DE)**

(54) **Stromsensor mit orthogonaler Ummagnetisiereinrichtung**

(57)   Die Erfindung betrifft eine Messanordnung zur berührungslosen Strommessung nach dem Prinzip der Messung des einen stromführenden Leiter (1) umgebenden Magnetfeldes der Flussdichte ($B_Z$), mit einem Magnetfeldkonzentrator (2) aus hochpermeablem Material, der um den stromführenden Leiter (1) herum angeordnet wird und diesen wenigstens teilweise um- schliesst, einer Spule (8) zur Erzeugung eines magne- tischen Feldes ($B_L$) im Magnetfeldkonzentrator (2), und einem Magnetfeldsensor (3). Zur Erhöhung der Mess- genauigkeit wird vorgeschlagen, die Spule (8) derart an- zuordnen, dass eine Ummagnetisierung des Magnet- feldkonzentrators (2) in eine Richtung erfolgt, in der der Magnetfeldsensor (3) nicht sensitiv ist.

Fig. 5

**Beschreibung**

Die Erfindung betrifft eine Messanordnung zur berührungslosen Strommessung gemäss dem Oberbegriff des Patentanspruchs 1, sowie ein Messverfahren zur Strommessung mit einer derartigen Messanordnung gemäss dem Oberbegriff des Patentanspruchs 8.

Stromsensoren der genannten Art arbeiten mit einem Magnetfeldsensor, der das von einem elektrischen Leiter erzeugte magnetische Feld misst und daraus den im Leiter fließenden Strom ermittelt. Als Magnetfeldsensoren werden insbesondere Hall-Sensoren, Magneto-Transistoren, magnetoresistive Widerstände, etc. verwendet.

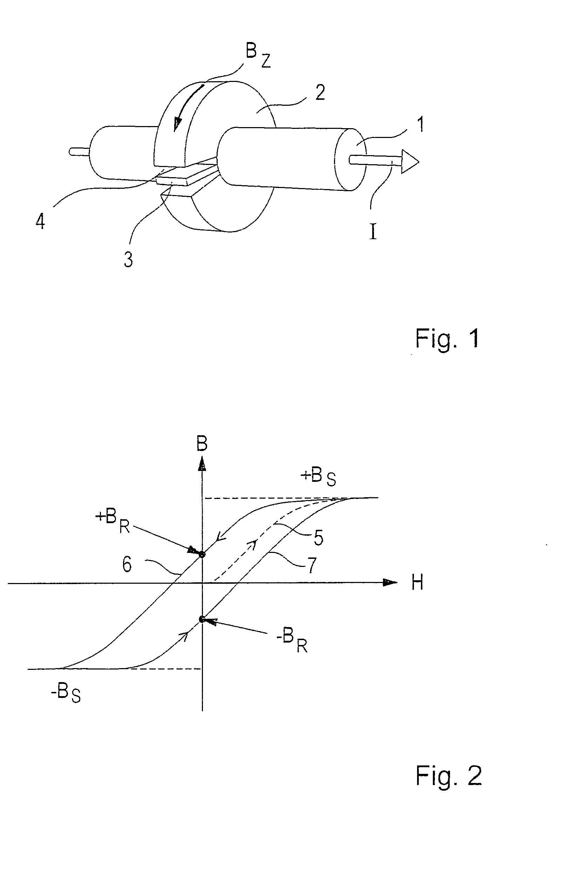

Ein aus dem Stand der Technik bekannter Stromsensor ist in Fig. 1 dargestellt. Fig. 1 zeigt ein Stromsensormodul mit einem stromführenden Leiter 1, der von einem Magnetfeldkonzentrator 2 umgeben ist, und einem Magnetfeldsensor 3, der in einem Luftspalt 4 des Magnetfeldkonzentrators 2 angeordnet ist.

Der Magnetfeldkonzentrator 2 (auch als Magnetkreis bezeichnet) dient im wesentlichen dazu, das vom Stromfluss I erzeugte zirkuläre magnetische Feld der Flussdichte $B_z$ zu konzentrieren und somit für die Messung mit dem Magnetfeldsensor 3 zu verstärken. Außerdem wird die Störempfindlichkeit des Sensors insbesondere an stark elektromagnetisch belasteten Einsatzorten, wie z.B. in der Umgebung eines Generators, wesentlich reduziert.

Magnetische Materialien, i.A. Ferrite oder nickel- und kobalthaltige Verbindungen, wie sie für den Magnetfeldkonzentrator 2 verwendet werden, zeigen ein Hysterese-Verhalten, das sich nachteilig auf die Messgenauigkeit des Stromsensors auswirkt.

Fig. 2 zeigt dieses Verhalten anhand der magnetischen Flussdichte B in einem hochpermeablen Material über der magnetischen Feldstärke H. Wenn das hochpermeable Material noch keinem Magnetfeld H ausgesetzt war und die sogenannten Weiß'schen Bezirke statistisch isotrop ausgerichtet sind, nimmt die Flussdichte B entsprechend der gestrichelt gezeichneten Neukurve 5 zu (linearer Bereich), bis ein bestimmter Sättigungswert $B_s$ erreicht ist. Nach Erreichen der Sättigungsflussdichte $+B_s$ bzw. $-B_s$ nimmt die magnetische Flussdichte B entsprechend der Kennlinien 6,7 ab bzw. zu, so dass auch ohne Anliegen eines magnetischen Feldes (H=0) eine remanente magnetische Flussdichte $+B_R$ bzw. $-B_R$ im Magnetfeldkonzentrator 2 zurückbleibt. Diese Restmagnetisierung (im folgenden vereinfacht als Remanenz bezeichnet) führt insbesondere bei kleinen Strömen zu erheblichen Messfehlern. Auch nach dem Abschalten des Stromes durch den Stromleiter 1 wird nämlich ein Messsignal im Magnetfeldsensor 3 erzeugt. Der Remanenzbeitrag des Magnetfeldes kann bei kleinen Strömen erheblich höher sein als der Magnetfeldbeitrag des Stromflusses.

Zur Verbesserung der Messgenauigkeit ist es bekannt, solche remanenten Ausrichtungen Weiß'scher Bezirke zu zerstören, indem der Magnetfeldkonzentrator 2 mit Hilfe einer Spule entmagnetisiert wird.

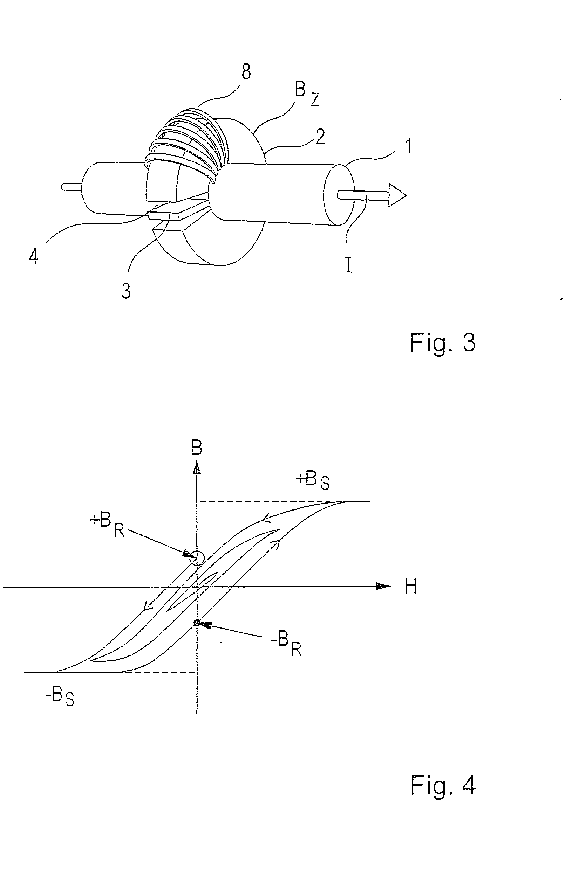

Fig. 3 zeigt einen aus dem Stand der Technik bekannten Stromsensor mit einer Entmagnetisierspule 8, die um den Magnetkreis 2 angeordnet ist. Die Spule 8 wird mit einem Strom beaufschlagt, der im Inneren der Spule 8 eine hinreichend hohe Magnetfeldstärke B erzeugt, um die gesamte Hysteresekurve (Fig. 2) bis zu den Sättigungspunkten +/-$B_s$ durchlaufen zu können.

Die Vorgehensweise bei der Entmagnetisierung des Magnetkreismaterials ist nochmals in Fig. 4 schematisch dargestellt. Durch Anlegen eines z.B. sinusförmig oszillierenden Stromes mit abklingender Amplitude an der Entmagnetisierspule 8 wird die in Fig. 4 dargestellt Hysteresekurve, wie dargestellt, rückwärts durchlaufen. Auf diese Weis kann erreicht werden, dass das Remanenzfeld mit abnehmendem Spulenstrom gegen Null abnimmt und im Idealfall zu Null wird. Ein Nachteil dieser Methode ist, dass die Entmagnetisierung relativ viel Energie verbraucht und eine Totzeit verursacht, in der der Magnetfeldsensor 3 nicht genutzt werden kann.

Es ist daher die Aufgabe der vorliegenden Erfindung, einen auf der Basis der Magnetfeldmessung arbeitenden Stromsensor zu schaffen, der eine wesentlich geringere Leistungsaufnahme und kürzere Totzeiten hat.

Gelöst wird diese Aufgabe gemäss der Erfindung durch die im Patentanspruch 1 bzw. 8 angegebenen Merkmale. Weitere Ausgestaltungen der Erfindung sind Gegenstand von Unteransprüchen.

Der wesentliche Gedanke der Erfindung besteht darin, den Magnetfeldkonzentrator nicht zu entmagnetisieren, sondern eine Ummagnetisierung des Magnetfeldkonzentrators orthogonal zur sensitiven Achse des Magnetfeldsensors durchzuführen. Dies bewirkt, dass die Weiß schen Bezirke im Magnetfeldkonzentrator in eine Richtung orthogonal zur sensitiven Achse des Magnetfeldsensors umklappen. Eine Remanenz bleibt zwar dadurch im Magnetfeldkonzentrator erhalten, sie wird jedoch vom Magnetfeldsensor nicht detektiert.

Zur Durchführung der Ummagnetisierung wird z.B. eine Spule vorzugsweise mit einem Stromimpuls beaufschlagt. Dabei wird die Stromstärke des Impulses so hoch gewählt, dass das Magnetkreismaterial in Richtung der Spulenachse die Sättigungsflussdichte erreicht. Nach Abschalten des Impulses bleibt dann eine remanente Ausrichtung der Weiß'sehen Bezirke entlang der Spulenachse zurück. Dies hat den Vorteil, dass ein kurzer intensiver Stromimpuls im Vergleich zur bekannten oszillierenden Entmagnetisierungsmethode erheblich weniger Energie verbraucht. Ausserdem ist die Totzeit des Stromsensors minimal, da anstelle einer abklingenden Oszillation nur ein kurzer Impuls erforderlich ist (z.B. <100µs).

Die Spule ist vorzugsweise derart angeordnet, dass die Spulenlängsachse orthogonal zur sensitiven Achse des Magnetfeldsensors steht.

Der Stromimpuls kann beispielsweise durch einen parallel zur Spule geschalteten Kondensator erzeugt werden, der von einer Energiequelle geladen wird und sich durch kurzes Einschalten eines Schalters über die Spule entlädt.

Wahlweise kann die Spule auch mit einem Wechselstrom oder durch periodisches Ein- und Ausschalten des Spulenstroms betrieben werden. Dadurch kann eine periodische Modulation des Magnetfeldes am Ort des Magnetfeldsensors erreicht werden. Die Permeabilität $\mu_r{}^{zirkular}$ des Magnetkreises in zirkularer Richtung wird somit eine Funktion des Spulenfeldes $H_{Spule}$, wobei gilt:

$$\mu_r{}^{zirkular} = f\,(H_{Spule}) \text{ und Somit } B^{zirkular} = f(I_{Stromleiter}, H_{Spule})$$

Da das zirkulare B-Feld, welches der Magnetfeldsensor misst, sowohl vom Strom $I_{Stromleiter}$ des zentralen Leiters als auch vom Feld $H_{Spule}$ der Spule abhängt, können auch sehr kleine zirkulare Felder unter Anwendung hochsensitiver Modulationstechnik (z.B. Lock-in-Verstärker) gemessen werden.

Gemäss einer bevorzugten Ausführungsform der Erfindung werden Spule, Stromleiter und Magnetfeldsensor in einer hochpermeablen Vergussmasse, z.B. in Polymer eingeschlossene Ferrite, eingebettet. Die Vergussmasse kann entweder selbst als Chipverpackung des Stromsensors dienen oder aber der Stromsensor (einschließlich der Auswertelogik) wird in einem eigenen Gehäuse (z.B. gemoldete Standardverpackung in Verbindung mit einem nichtmagnetischen Leadframe) untergebracht.

Gemäss einer anderen Ausführungsform der Erfindung umfasst das Stromsensormodul zwei vorzugsweise identische Magnetfeldsensoren, die so angeordnet sind, dass sie vom zirkularen Messfeld des Magnetfeldkonzentrators in entgegengesetzter Richtung durchflutet werden. Homogene Störfelder, sofern sie nicht bereits durch den Magnetkreis abgeschirmt werden, werden von beiden Magnetfeldsensoren mit gleichem Vorzeichen gemessen, während das zu messende Magnetfeld des Stromleiters mit entgegengesetzten Vorzeichen gemessen wird. Bei geeigneter Addition der Messsignale der gegeneinander verschalteten Magnetfeldsensoren heben sich die Störbeiträge hinreichend homogener Störfelder auf, während sich die Beiträge des Messfeldes addieren.

Gemäss der Erfindung kann der bzw. die Magnetfeldsensoren entweder separat verpackt, als auch zusammen mit der Ansteuer-/Auswertelogik in einem einzigen Gehäuse eingebaut sein. Die Sensoren können auch zusammen mit der Logik auf einem einzigen Chip, z.B. in einem BCD-Prozess monolithisch integriert werden.

Die Erfindung wird nachstehend anhand der beigefügten Zeichnungen beispielhaft näher erläutert. Es zeigen:

Fig. 1 einen aus dem Stand der Technik bekannten Stromsensor;

Fig. 2 eine schematische Darstellung der Hysterese eines hochpermeablen Materials;

Fig. 3 einen aus dem Stand der Technik bekannten Stromsensor mit Entmagnetisierspule;

Fig. 4 eine schematische Darstellung eines Entmagnetisierzyklus;

Fig. 5 einen Stromsensor mit einer Ummagnetisierspule gemäss einer Ausführungsform der Erfindung;

Fig. 6 eine Ausführungsform einer Beschaltung für die Ummagnetisierspule von Fig. 5;

Fig. 7 einen Stromsensor entsprechend Fig. 5, der von einem Mantel aus hochpermeablem Material umgeben ist;

Fig. 8 einen Stromsensor mit zwei Magnetfeldsensoren; und

Fig. 9 ein Flussdiagramm zur Darstellung der Verfahrensschritte beim Ummagnetisieren des Magnetkreises.

Bezüglich der Erläuterung der Figuren 1 bis 4 wird auf die Beschreibungseinleitung verwiesen.

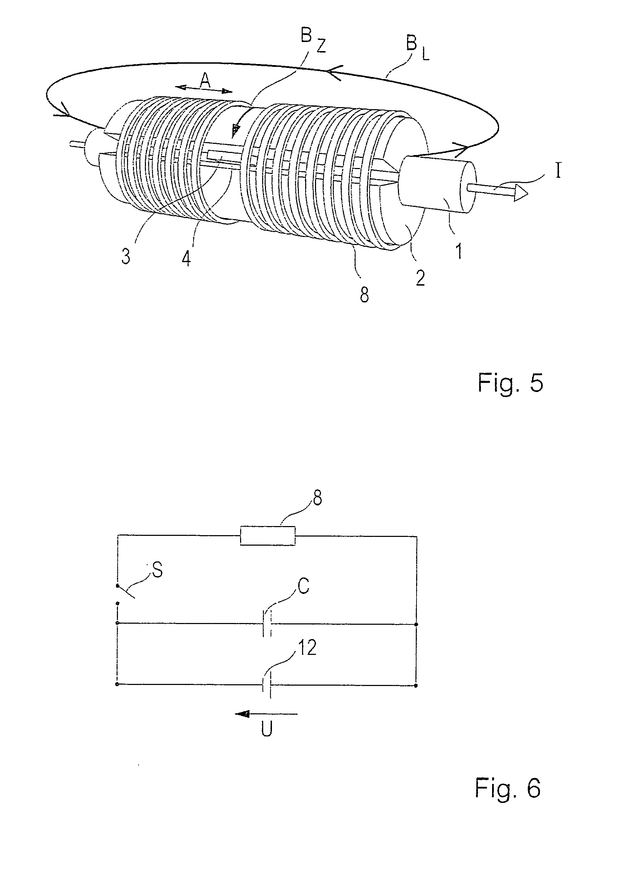

Fig. 5 zeigt eine Messanordnung zur Bestimmung des durch einen Leiter 1 fliessenden Stromes I, mit einem um den Leiter 1 herum angeordneten Magnetfeldkonzentrator 2 (Magnetkreis) und einem Magnetfeldsensor 3, der in einem Luftspalt 4 des Magnetkreises 2 angeordnet ist. Zur Vermeidung von Messfehlern auf Grund remanenter zirkularer Magnetfelder ist eine Ummagnetisierspule 8 vorgesehen, deren Spulenachse in Längsrichtung (Pfeil A) des Leiters 1 ausgerichtet ist.

Durch Ausüben eines kurzen Stromimpulses werden die Weiß schen Bezirke im Material des Magnetfeldkonzentrators 2 in eine Richtung orthogonal zur sensitiven Achse (d.h. in Richtung des Pfeils A) des Magnetfeldsensors 3 umgeklappt. Somit hat das Remanenzfeld keine Komponente mehr, die vom Magnetfeldsensor 3 detektiert wird.

Die Stromstärke des Impulses muss so hoch gewählt werden, dass das Magnetkreismaterial in Richtung der Spulenachse (Pfeil A) die Sättigungsflussdichte $B_s$ erreicht. Nach dem Abschalten des Impulses bleibt dann eine remanente Ausrichtung der Weiß schen Bezirke entlang der Spulenachse A zurück.

Der Stromimpuls kann z.B. durch eine Beschaltung erzeugt werden, wie sie in Fig. 6 dargestellt ist. Fig. 6 zeigt eine Schaltung mit einem parallel zur Spule 8 geschalteten Kondensator C, der von einer Energiequelle 12 aufgeladen wird und der sich durch kurzes Einschalten eines Schalters S über die Spule 8 entlädt. Der Schalter S kann z.B. ein zwischen Kondensator C und Spule 8 angeordneter Transistor sein.

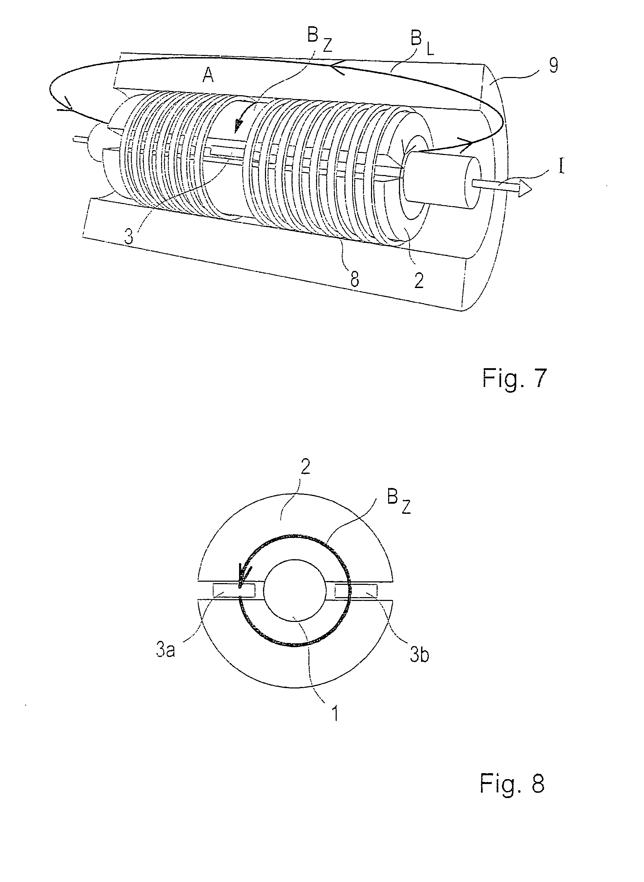

Fig. 7 zeigt nochmals die Messanordnung von Fig. 5, die zusätzlich von einem Mantel 9 aus hochpermeablem Material eingehüllt ist. Der Mantel 9 dient im wesentlichen zur Erzeugung eines äusseren Magnetkreises, der die Feldlinien $B_L$ der Spule 8 konzentriert. Gleichzeitig ist er auch als Abschirmung gegen externe Störfelder wirksam.

Der innere Magnetkreis 2 und der Mantel 9 können vorteilhaft in einem einzigen Herstellungsschritt aus einer hochpermeablen Vergussmasse hergestellt werden, die den Stromleiter 1, die Spule 8 und den Magnetfeldsensor 3 umschliesst. Die elektrischen Anschlüsse des Magnetfeldsensors 3 sind in geeigneter Weise herauszuführen.

Fig. 8 zeigt eine Ausführungsform eines Stromsensors mit zwei Magnetfeldsensoren 3a, 3b. Die Magnetfeldsensoren 3a, 3b sind dabei derart im Magnetfeldkonzentrator 2 angeordnet, dass sie vom zirkularen Magnetfeld $B_z$ in entgegengesetzter Richtung durchflutet werden. Homogene Störfelder werden somit von beiden Magnetfeldsensoren 3a, 3b mit gleichem Vorzeichen gemessen, während das zu messende zirkulare Magnetfeld $B_z$ mit entgegengesetzten Vorzeichen gemessen wird. Bei einer Addition der Messsignale der gegeneinander geschalteten Magnetfeldsensoren 3a, 3b heben sich dadurch automatisch die Störbeiträge hinreichend homogener Störfelder auf, während sich die Signale des zu messenden zirkularen Magnetfeldes $B_z$ addieren.

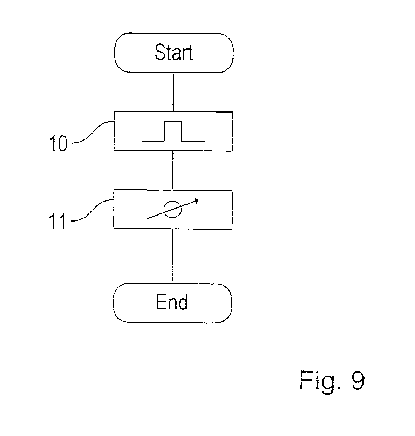

Fig. 9 zeigt die Verfahrensschritte beim Betrieb der Ummagnetisierspule 8 mit Stromimpulsen wobei in einem Schritt 10 die Spule 8 zunächst mit einem kurzen intensiven Stromimpuls beaufschlagt wird, der zu der beschriebenen Ummagnetisierung des Magnetfeldkonzentrators 2 orthogonal zur sensitiven Achse des Magnetfeldsensors 3 führt. In Schritt 11 kann dann eine Messung ohne den Störeinfluss remanenter Magnetfelder in zirkularer Richtung $B_z$ durchgeführt werden.

Wahlweise kann die Spule 8 auch zur Modulation des zirkularen Magnetfeldes $B_z$ verwendet werden. Dabei wird an die Spule 8 ein Wechselstrom oder ein periodisches Ein-/Aus-Signal angelegt, mit dem das zirkulare Magnetfeld $B_z$ des Leiters 1 beeinflusst wird. Die Permeabilität in zirkularer Richtung wird somit eine Funktion des Spulenfeldes $H_{Spule}$. Auf diese Weise kann z.B. ein Lock-in-Verstärker zur Messung sehr kleiner zirkularer Felder $B_z$ angewendet werden.

Bezugszeichenliste

| | |
|---|---|
| 1 | elektrischer Leiter |
| 2 | Magnetfeldkonzentrator |
| 3 | Magnetfeldsensor |
| 4 | Luftspalt |
| 5 | Linearer Bereich |
| 6, 7 | Äste der Hysteresekurve |
| 8 | Spule |
| 9 | Mantel aus hochpermeablem Material |
| 10, 11 | Verfahrensschritte |
| 12 | Energiequelle |
| C | Kondensator |
| U | Spannung |
| S | Schalter |
| $B_z$ , $B_L$ | magnetische Flussdichte |

**Patentansprüche**

1. Messanordnung zur berührungslosen Strommessung, der nach dem Prinzip der Messung des einen stromführenden Leiter umgebenden Magnetfeldes arbeitet, umfassend:

- einen Magnetfeldkonzentrator (2) aus hochpermeablem Material, der um den stromführenden Leiter (1) herum angeordnet wird und diesen wenigstens teilweise umschliesst,
- eine Spule (8) zur Erzeugung eines magnetischen Feldes mit einer Flussdichte ($B_z$) im Magnetfeldkonzentrator (2), sowie
- einen im Bereich der magnetischen Flussdichte (B$_z$) des Magnetfeldkonzentrators (2) angeordneten Magnetfeldsensor (3),

**dadurch gekennzeichnet, dass** die Spule (8) derart angeordnet ist, dass bei Betrieb der Spule (8) eine Ummagnetisierung des Magnetfeldkonzentrators (2) in eine Richtung erfolgt, in der der Magnetfeldsensor (3) nicht sensitiv ist.

2. Messanordnung nach Anspruch 1, **dadurch gekennzeichnet, dass** die Spule (8) mit kurzen Stromimpulsen beaufschlagt wird, so dass ein remanenter magnetischer Fluss (B$_L$) in einer Richtung erzeugt wird, in der der Magnetfeldsensor (3) nicht sensitiv ist.

3. Messanordnung nach Anspruch 1 oder 2, **dadurch gekennzeichnet, dass** die Spule (8) derart angeordnet ist, dass die Spulenachse (A) in Längsrichtung des Leiters (1) verläuft.

4. Messanordnung nach einem der vorhergehenden Ansprüche,
**dadurch gekennzeichnet, dass** die Spule (8) an ihrer Außenseite wenigstens teilweise von einem Material (9) mit hoher magnetischer Permeabilität umgeben ist.

5. Messanordnung nach einem der vorhergehenden Ansprüche,
**dadurch gekennzeichnet, dass** der Leiter (1), der Magnetfeldsensor (3) und die Spule (8) in einer Vergussmasse eingebettet sind, die gleichzeitig als Magnetfeldkonzentrator (2) und als äusserer Magnetkreis wirkt.

6. Messanordnung nach Anspruch 1, **dadurch gekennzeichnet, dass** die Spule (8) mit Wechselstrom betrieben wird.

7. Messanordnung nach einem der vorhergehenden Ansprüche,
**dadurch gekennzeichnet, dass** ein erster und ein zweiter Magnetfeldsensor (3a,3b) vorgesehen sind, die vom zirkularen Magnetfeld (B$_z$) des Magnetfeldkonzentrators (2) in entgegengesetzter Richtung durchflutet werden.

8. Verfahren zur berührungslosen Strommessung mit einer Messanordnung mit einem stromführenden Leiter (1), einem den Leiter (1) wenigstens teilweise umgebenden Magnetfeldkonzentrator (2) aus hochpermeablem Material, einer Spule (8) zur Erzeugung eines Magnetfeldes (B$_z$) im Magnetfeldkonzentrator (2) und einem Magnetfeldsensor (3), **gekennzeichnet durch** folgende Schritte:

   - Ummagnetisieren (10) des Magnetfeldkonzentrators (2) in eine Richtung, in der der Magnetfeldsensor (3) nicht sensitiv ist, und
   - Durchführen einer Strommessung (11).

9. Verfahren nach Anspruch 8, **dadurch gekennzeichnet, dass** die Spule (8) mittels Stromimpulsen (10) betrieben wird, die zu einem remanenten magnetischen Fluss (B$_L$) im Magnetfeldkonzentrator (2) in einer Richtung führen, in der der Magnetfeldsensor (3) nicht sensitiv ist.

10. Verfahren nach Anspruch 8, **dadurch gekennzeichnet, dass** die Spule (8) mit Wechselstrom betrieben wird.

$B_Z$

2

1

4

3

I

Fig. 1

B

$+B_S$

$+B_R$

6

5

7

H

$-B_R$

$-B_S$

Fig. 2

Fig. 3

Fig. 4

Fig. 5

Fig. 6

Fig. 7

Fig. 8

Fig. 9

**Europäisches Patentamt**

# EUROPÄISCHER RECHERCHENBERICHT

Nummer der Anmeldung

EP 03 00 9025

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| A | DE 198 45 778 A (SIEMENS AG) 13. April 2000 (2000-04-13) * Spalte 3, Zeile 34 - Zeile 56; Abbildung 1 * --- | 1,8 | G01R19/00 G01R15/18 G01R15/20 |
| A | PATENT ABSTRACTS OF JAPAN vol. 1997, no. 10, 31. Oktober 1997 (1997-10-31) & JP 09 166626 A (U R D:KK), 24. Juni 1997 (1997-06-24) * Zusammenfassung * --- | 1,8 | |
| A | US 5 177 433 A (SCHWENDTNER MANFRED ET AL) 5. Januar 1993 (1993-01-05) * Spalte 2, Zeile 66 - Spalte 3, Zeile 13; Abbildungen 4,5 * ----- | 1,8 | |

RECHERCHIERTE SACHGEBIETE (Int.Cl.7)

G01R

Der vorliegende Recherchenbericht wurde für alle Patentansprüche erstellt

| Recherchenort | Abschlußdatum der Recherche | Prüfer |
|---|---|---|
| DEN HAAG | 27. November 2003 | Heinsius, R |

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 03 00 9025

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

27-11-2003

| Im Recherchenbericht angeführtes Patentdokument | | Datum der Veröffentlichung | Mitglied(er) der Patentfamilie | | Datum der Veröffentlichung |
|---|---|---|---|---|---|
| DE 19845778 | A | 13-04-2000 | DE | 19845778 A1 | 13-04-2000 |
| | | | WO | 0017663 A2 | 30-03-2000 |
| | | | EP | 1116040 A2 | 18-07-2001 |
| | | | JP | 2002525608 T | 13-08-2002 |
| JP 09166626 | A | 24-06-1997 | KEINE | | |
| US 5177433 | A | 05-01-1993 | EP | 0438616 A1 | 31-07-1991 |
| | | | AT | 104774 T | 15-05-1994 |
| | | | CA | 2034636 A1 | 24-07-1991 |
| | | | DE | 59005455 D1 | 26-05-1994 |
| | | | DK | 438616 T3 | 29-08-1994 |
| | | | ES | 2051393 T3 | 16-06-1994 |
| | | | FI | 910009 A | 24-07-1991 |

EPO FORM P0461

Für nähere Einzelheiten zu diesem Anhang : siehe Amtsblatt des Europäischen Patentamts, Nr. 12/82